Europäisches Patentamt

European Patent Office

Office européen des brevets

(19)

(11) Veröffentlichungsnummer: **0 095 756**
**A1**

(12) **EUROPÄISCHE PATENTANMELDUNG**

(21) Anmeldenummer: **83105283.2**

(22) Anmeldetag: **27.05.83**

(51) Int. Cl.³: **C 30 B 15/00,** C 30 B 13/00,
C 30 B 13/16, C 30 B 29/06,
C 01 B 33/02

(30) Priorität: **28.05.82 DE 3220343**

(43) Veröffentlichungstag der Anmeldung: **07.12.83**
**Patentblatt 83/49**

(84) Benannte Vertragsstaaten: **DE FR IT**

(71) Anmelder: **SIEMENS AKTIENGESELLSCHAFT, Berlin**
**und München Wittelsbacherplatz 2,**
**D-8000 München 2 (DE)**

(72) Erfinder: **Keller, Wolfgang, Dr. rer. nat.,**
**Kurt-Floericke-Strasse 8, D-8000 München 60 (DE)**
Erfinder: **Ludsteck, Alexander, Dr. rer. nat.,**
**Arno-Assmann-Strasse 2, D-8000 München 83 (DE)**
Erfinder: **Fenzl, Hans J., Dipl.-Ing., Soxhletstrasse 6,**
**D-8000 München 40 (DE)**

(54) **Verfahren zum Herstellen polykristalliner Siliciumstäbe.**

(57) Zur Verbesserung des Wirkungsgrades von in der Solar-
technik einsetzbaren Siliciums wird billiges im Lichtbogenverfahren gewonnenes Silicium einem Zonenziehprozeß unterzogen, dies geschieht dadurch, daß die Siliciumschmelze in ein
horizontal angeordnetes Boot gefüllt und auf eine Arbeitstemperatur abgekühlt wird, die deutlich unterhalb der Schmelztemperatur aber oberhalb eines Wertes liegt, bei dem das Silicium seine Plastizität verliert, daß dann das erstarrte aber noch
auf erhöhte Arbeitstemperatur befindliche Silicium in dem
Boot einem Zonenschmelzprozeß unterzogen wird, daß
schließlich das Silicium auf Zimmertempertur abgekühlt und
aus dem Boot entfernt wird.

0095756

SIEMENS AKTIENGESELLSCHAFT          Unser Zeichen
Berlin und München                 VPA 82 P 1 4 2 5 E

Verfahren zum Herstellen polykristalliner Siliciumstäbe

Zur großtechnischen Umwandlung von Sonnenenergie in elektrische Energie werden bevorzugt Solarzellen aus kristallinem Silicium eingesetzt. Dabei ist es wünschenswert, reines aber kostengünstiges Silicium einzusetzen, aus dem sich Solarzellen mit einem hohen Wirkungsgrad von beispielsweise mehr als 10 % herstellen lassen.

Zur Herstellung von Solarzellen mit hohem Wirkungsgrad wird heute allgemein hochreines Silicium als Grundmaterial verwendet, das durch thermische Zersetzung von mit Wasserstoff verdünntem, gasförmigen, hochreinen Siliciumverbindungen wie Silicochloroform oder Siliciumtetrachlorid und Abscheidung auf widerstandsbeheizten Silicumdünnstäben bei einer Temperatur von ca. 1100°C gewonnen wird. Die auf diese Weise hergestellten Siliciumpolystäbe werden durch einen anschließenden Kristallziehprozeß, z. B. durch tiegelfreies Zonenschmelzen, nachgereinigt, in einen Kristall übergeführt, in Scheiben zersägt, und zu Solarzellen weiterverarbeitet. Dieses Verfahren ist technisch relativ aufwendig und daher für die großtechnische Siliciumherstellung zu teuer.

Silicium für technische Anwendungen mit einem zwar wesentlich niedrigeren Reinheitsgrad von beispielsweise 98,5 % wird heute großtechnisch durch Reduktion von Quarz mit Kohlenstoff im Lichtbogenofen hergestellt. Dieser Prozeß arbeitet zwar wirtschaftlich,

Bar 1 Gae / 26.05.1982

er ist jedoch nur dann zur Herstellung von Solarsilicium geeignet, wenn es gelingt, den bisher erzielten Reinheitsgrad entscheidend zu erhöhen.

Zu diesem Zweck wurde in der deutschen Patentanmeldung P 32 10 141.4 (VPA 82 P 1201 DE) bereits vorgeschlagen, das nach dem Lichtbogenverfahren gewonnene Silicium in Stabform überzuführen und durch anschließendes, tiegelfreies Zonenschmelzen von den störenden Verunreinigungen zu befreien.

Es ist aber nicht so ohne weiteres möglich, diesen Vorschlag zu verifizieren.

Zunächst haben die Versuche mit Eisen- oder Sandformen, wie sie in der Gießtechnik üblich sind, gezeigt, daß diese bei Metallen üblichen Standardverfahren, wegen der hohen Reaktivität des flüssigen Siliciums und der Ausdehnung des Siliciums während des Erstarrens nicht zu brauchbaren Ergebnissen führen.

Andererseits hat sich aber auch gezeigt, daß es nicht so ohne weiteres möglich ist, gegossenes Silicium durch Zonenschmelzen preiswert zu reinigen. Entweder wird im Gegensatz zum durch thermische Zersetzung gewonnenen Silicium dieses mit vielen Rissen, Lunkern, Bläschen, Einschlüssen und sonstigen Kristallstörungen erhalten oder der Zonenschmelzprozeß muß sehr oft, manchmal mehr als 6 bis 7 mal, wiederholt werden, um ein einigermaßen brauchbares Silicium zu erhalten.

Einige Überlegungen gehen von der Erkenntnis aus, daß die technische Qualität des zonengezogenen Solarsiliciums wesentlich verbessert werden kann, wenn das dem Zonenschmelzprozeß zu unterwerfende Silicium nicht nur riß- und lunkerfrei ist. Es soll auch frei von störenden Oberflächenschichten sein und bereits höhere Kristallqualität besitzen. Bei qualitativ höherwertigem Silicium gelingt es sogar mit wenigen Zonenzügen versetzungsfreies einkristallines Silicium zu gewinnen, das selbst für manche anspruchsvollere Halbleiterbauelemente geeignet ist.

Die Erfindung geht aber von der Erkenntnis aus, das aufwendige tiegelfreie Zonenschmelzen durch eine Reinigungskristallisation in dem Gießgefäß selbst zu ersetzen. Mit einem einfachen Gefäß ist das Problem nicht lösbar, da sich Silicium bei Schmelztemperatur sehr aggressiv gegen die meisten Tiegelmaterialien verhält und sich beim Erstarren ausdehnt.

Die Erfindung sieht daher vor, beim Herstellen polykristalliner Siliciumstäbe die Siliciumschmelze in ein horizontal angeordnetes Boot zu füllen und die Schmelze auf eine Arbeitstemperatur abzukühlen, die deutlich unterhalb der Schmelztemperatur aber oberhalb eines Wertes liegt, bei dem das Silicium seine Plastizität verliert, danach das erstarrte aber noch auf erhöhter Arbeitstemperatur befindliche Silicium in dem gleichen Boot einem Zonenschmelzprozeß zu unterziehen, um schließlich das Silicium auf Zimmertemperatur abzukühlen und aus dem Boot zu entfernen.

Als geeignete Arbeitstemperatur hat sich der Bereich zwischen 700° und 1300°C insbesondere um 1000°C erwiesen.

Wenn der Siliciumbarren auf dieser mittleren Arbeitstemperatur gehalten wird, ist es möglich, auch Silicium sinnvoll im Boot zonenzuschmelzen, einerseits ist der

0095756

erforderliche energetische Aufwand bei dem enormen. Kostendruck des Solarsiliciums noch vertretbar, andererseits ist auch die beim Barrengießen und jedem Zonenzug auftretende thermische Beanspruchung, insbesondere auch durch die erfindungsgemäße Ausgestaltung des Bootes, noch gering.

Es ist sowohl möglich nur eine einzelne Schmelzzone. als auch mehrere Schmelzzonen gleichzeitig mit einer Geschwindigkeit von etwa 1 bis 10 mm pro Minute durch den Siliciumstab hindurchzuführen.

Ist die Abkühlung des Siliciums in dem Boot derart durchgeführt worden, daß die Phasengrenze fest/flüssig von einem Ende des Bootes zum anderen wandert, so wird beginnend vom zuerst erstarrten Ende des Stabes das Silicium wieder z. B. durch induktives Heizen lokal aufgeschmolzen. Die Heizspule wird so über die Form geführt, daß die lokale Schmelzzone den Stab in der gleichen Richtung durchläuft wie die Erstarrungs-Phasengrenze fest/flüssig.

Der Zonenschmelzprozeß im Tiegel kann sowohl mittels Hochfrequenzheizung d.h. bei Frequenzen zwischen ca. 0,1 und 1, 5 MHz, als auch mittels Mittelfrequenzheizung, d.h. bei Frequenzen zwischen ca. 10 und 100 kHz, durchgeführt werden.

Um eine vernünftige Segregation zu erhalten, ist es zweckmäßig, die Breite der Schmelzzonen auf etwa 10 cm zu begrenzen. Bei den üblichen Kurzstäben von 1 bis 1,5 Metern bedeutet dies eine Beschränkung der Breite der Schmelzzone auf etwa 1 Zehntel der Bootslänge.

0095756

Bei der Herstellung von Langstäben, von z. B. 5 bis 10 m Länge, ist es zweckmäßig mehrere Schmelzzonen gleichzeitig durch den Stab zu führen. Da die einzelnen Schmelzzonen aber soweit voneinander entfernt sein müssen, daß zwischen den Schmelzzonen das Silicium wieder auf seine mittlere Arbeitstemperaturen von beispielsweise 1000°C abkühlt, sollten die energetischen Verhältnisse insbesondere die der Induktionsheizspule so eingestellt sein, daß der mittlere Abstand der einzelnen Schmelzzonen höchstens 50 cm beträgt.

Zur besseren Durchmischung der Schmelze kann der Siliciumbarren während des Zonenschmelzprozesses mechanischen Rüttelbewegungen ausgesetzt, insbesondere mit Ultraschall behandelt werden.

Der Umschmelzprozeß kann sowohl im Vakuum als auch im Schutzgas bei reduziertem Druck durchgeführt werden. Bei Mittelfrequenz und Verwendung von Argon oder Wasserstoff hat sich ein Partialdruck von 10 mbar als besonders günstig erwiesen. Bei Hochfrequenz sind höhere Gasdrücke von beispielsweise mehreren 100 mbar erforderlich.

Nach dem Zonenschmelzprozeß im Boot, so sieht es eine Weiterbildung der Erfindung vor, wird das dem Boot entnommene Barrensilicium von an der Oberfläche haftenden Verunreinigungen befreit. Dies geschieht in an sich bekannter Weise z. B. durch Absägen, Abschleifen, Abätzen und Sandstrahlen. Zu den abzutragenden Teilen gehören sowohl oberflächliche, z. B. vom Boot her stammende als auch in die Siliciumoberfläche z. B. durch Diffusion und/oder Legierung eingedrungene Fremdstoffe; selbstverständlich ist auch das Stabende in dem sich die beim Zonenschmelzen hingeführten Verunreinigungen befinden, abzutrennen.

Ein solchermaßen vorbehandeltes Barrensilicium läßt sich nach dem Schneiden in Scheiben unmittelbar für Solarelemente verwenden. Wegen der Güte des beim erfindungsgemäßen Verfahren erhaltenen Siliciums - es handelt sich dabei um großkristallines reines Silicium mit einer Reinheit von mindestens 99,99 % - kann dieses auch zur Fertigung von Bauelementen die anspruchsvolleres, insbesondere einkristallines und versetzungsfreies Silicium verlangen, verwendet werden. Die Einkristallinität verbunden mit einem weiteren Reinigungsschritt wird wie an sich bekannt, dadurch erhalten, daß man das nach dem erfindungsgemäßen Verfahren erzeugte Barrensilicium entweder in einem Tiegel einschmilzt und mit Hilfe eines einkristallinen Keimes nach dem s.g. Czochralski-Verfahren aus dem Tiegel zieht oder einem tiegelfreien Zonenschmelzprozeß unterzieht.

Wurde ein Boot mit etwa halbkreisförmigem Querschnitt verwendet, so ist es sogar möglich, zwei gegeneinander gelegte und geeignet verspannte halbzylindrische Barren gemeinsam einem tiegellosen Zonenschmelzprozeß zu unterziehen.

Die Vorrichtung zur Durchführung des erfindungsgemäßen Verfahrens besteht im wesentlichen aus einem horizontal angeordneten Boot, das durch seine Formgebung die radiale thermische Ausdehnung des Siliciums aufzunehmen in der Lage ist, dem eine Kühl- und Heizeinrichtung, die die mittlere Temperatur des Siliciums auf der Arbeitstemperatur hält, und mindestens eine in Längsrichtung

0095756

des Bootes bewegbare, das Boot umschließende Induktionsheizspule zugeordnet sind.

Das Boot das beispielsweise aus Keramik oder insbesondere an der der Schmelze zugewandten Seite aus verdichtetem Graphit besteht, kann sowohl als Kurzboot mit einer Länge von 1 bis 1,5 m, insbesondere für die konventionellen Anwendungsgebiete, als auch als Langboot mit mehreren Metern, z. B. 5 bis 10 m Länge insbesondere für Solaranwendungen, ausgebildet sein.

Als Querschnittsform für das Boot kommen neben der Halbkreisform besonders die flächendeckenden Formen in Frage. Zu den flächendeckenden Formen zählen insbesondere Quadrate, Rechtecke, Trapetze und gleichschenklige Dreiecke.

Die während des Erstarrens der Schmelze auftretende radiale Ausdehnung des Siliciums wird dadurch aufgenommen, daß das Boot mehrfach längsgeteilt ist, wobei das Boot entweder aus wenigstens drei elastisch miteinander verbundenen Teilen besteht oder eine Vielzahl von über die gesamte Bootsoberfläche gleichmäßig oder nach irgendwelchen Mustern verteilte Längsschlitze besitzt.

Zur Vermeidung von Reaktionen der Siliciumschmelze mit der Bootswandung ist es sinnvoll bei Verwendung von Graphit seine Innenoberfläche noch zu verdichten, vorzugsweise auf Dichten von mehr als 1,85 g/cm$^3$. Es ist ebenso möglich, die Bootsinnenwandung mit einer Zwischenschicht auszukleiden. Sie kann aus Quarzsand beispielsweise aus mit einem Binder verfestigten Quarzsand bestehen. Als Zwischenschicht kann auch ein Graphitgewebe eingefügt werden.

Die Erfindung wird anhand zweier als Ausführungsbeispiele zu wertende Figuren näher erläutert.

Kernstück der erfindungsgemäßen Vorrichtung ist das horizontal angeordnete Boot 1 aus Keramik, das bekanntlich nicht siliciumfest ist. Das Boot mit einem rechteckförmigen Querschnitt hat zur Aufnahme der radialen Ausdehnung des Siliciums drei Längsschlitze 2, 3 und 4. Die einzuhaltende Schlitzbreite und damit auch die erforderliche Anzahl der Schlitze ist eine Frage der Benetzung des Siliciums. Schlitzbreiten von 1 mm sind bei der erfindungsgemäßen Vorrichtung mit Erfolg angewendet worden.

Die Bootsinnenseite besitzt eine Auskleidung 5 aus Quarzsandschichten, die mit einem Binder, z. B. Silikat oder Silikagel verfestigt wurde. Zur Abkühlung der Siliciumschmelze und zum Halten auf der mittleren Arbeitstemperatur von etwa 1000$^{\circ}$C dient eine in der Zeichnung symbolisch angedeutete Kühl- und Heizeinrichtung 6. Das Boot umschließt eine Induktionsheizspule 8, die in Richtung der Bootachse kontinuierlich bewegbar ist. Sie besitzt an ihren Enden 9 und 10 Anschlüsse für die hochfrequente Speisespannung von beispielsweise 1,5 MHz. Sie ist als Hohlrohr ausgebildet, um, wie durch die Pfeile 11 und 12 angedeutet, Kühlwasser führen zu können.

Das im Reaktionsofen erzeugte schmelzflüssige Silicium wird bei einer Temperatur zwischen 1430$^{\circ}$ und 1470$^{\circ}$C, vorzugsweise bei etwa 1450$^{\circ}$ C in einem Zuge aus einem in der Zeichnung nicht dargestellten Vorratsgefäß, das selbstverständlich auch der Abstichofen selbst sein kann, in das Boot 1, 5 gegossen.

Die Kühl- und Heizeinrichtung 6 bringt die Schmelze auf die mittlere Arbeitstemperatur von 1000°C. Besonders vorteilhaft ist es, wenn dieser erste Abkühlvorgang gerichtet erfolgt, und zwar in Richtung der Bootachse, wobei die Phasengrenze fest/flüssig von einem Ende des Bootes zum anderen wandert. Sobald ein ausreichend großer Teil des Siliciums auf die Arbeitstemperatur abgekühlt ist, kann, beginnend vom verfestigten Ende des Stabes, das Silicium durch die induktive Wirkung der Heizspule wieder lokal, d.h. als schmale Siliciumschmelzzone 7 aufgeschmolzen werden. Die erste Erstarrungsfront und die schmalen induktiv erzeugten Schmelzzonenbereiche - es können eine oder mehrere sein - bewegen sich in einem vorgegebenen Abstand zum anderen Bootsende hin. Die Schmelzzone selbst sollte, um den Reinigungseffekt zu optimieren, möglichst schmal gehalten werden und eine Breite von 10 cm tunlichst nicht überschreiten.

Wird die Erstarrungsfront mit 1 mm pro Minute durch den Barren geführt, so kann die Geschwindigkeit, mit der die Schmelzzone bewegt wird, gleichgroß gewählt werden und außerdem haben bei dieser Geschwindigkeit auch die Schlacken und sonstigen festen und groben Verunreinigungen wie Kohle, Siliciumcarbid- und Quarzstückchen genügend Zeit mit der Erstarrungsfront zur freien Oberfläche nach oben zu schwimmen.

Nach dem Zonenschmelzvorgang, der entsprechend den an das Silicium zu stellenden Reinheitsforderungen beliebig oft wiederholt werden kann, wird das Barrensilicium auf Zimmertemperatur abgekühlt, dem Boot entnommen und von Oberflächenverunreinigungen befreit.

Das so erhaltene Silicium kann unmittelbar zu Bauelementen verarbeitet werden oder aber auch einem
weiteren Veredlungsprozeß wie Tiegelziehen oder
tiegelfreies Zonenschmelzen zugeführt werden.

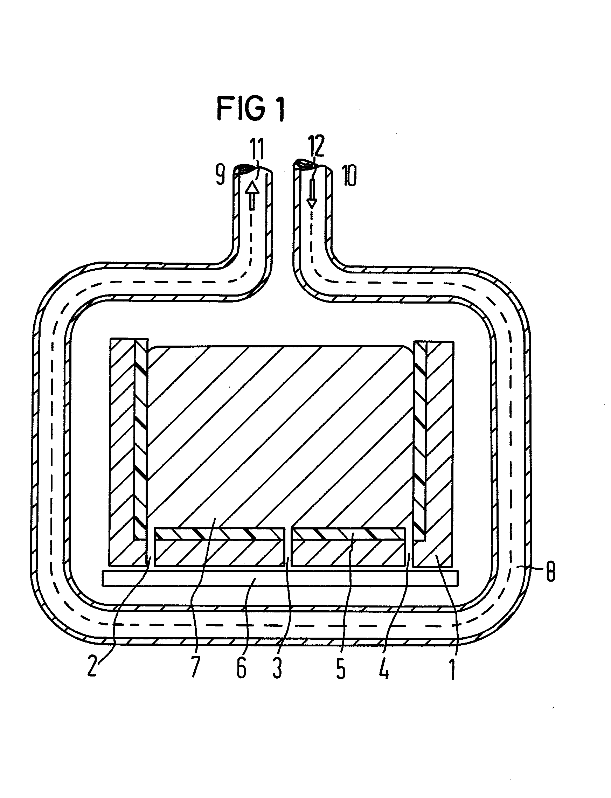

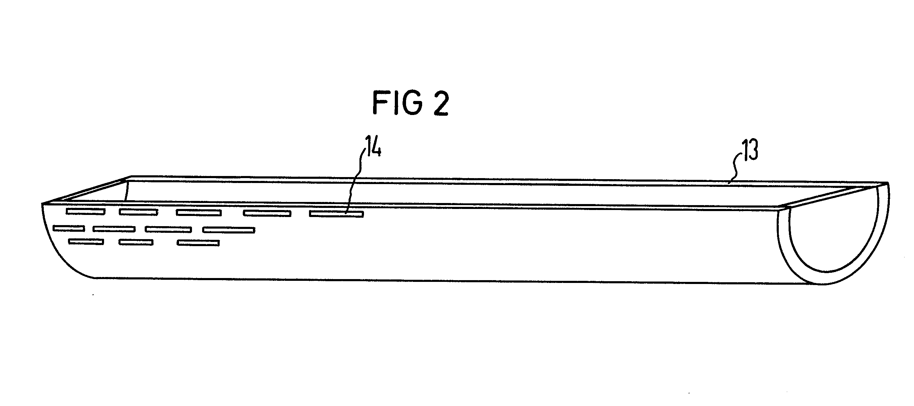

Fig. 2 zeigt eine weitere Möglichkeit durch die Formgebung des Bootes die radiale Ausdehnung des Siliciums
während der wiederholten Änderungen des Aggregatzustandes des Siliciums aufzunehmen. Das Langboot 13
aus Graphit hat eine Länge von 3 m und einen halbkreisförmigen Querschnitt. Die Bootsoberfläche besitzt eine
Vielzahl gleichmäßig oder gesetzmäßig verteilter
Längsschlitze 14, die das Boot elastisch gestalten. Die
Tiefe der Schlitze entspricht der Bootswanddicke, die
Schlitzlänge beträgt beispielsweise 2 cm bei einer
Breite von etwa 1 mm.

Patentansprüche

1. Verfahren zum Herstellen polykristalliner Siliciumstäbe durch Gießen flüssigen Siliciums in formgebende
Behältnisse mit anschließendem Erstarrenlassen,
d a d u r c h   g e k e n n z e i c h n e t , daß die
Siliciumschmelze in ein horizontal angeordnetes Boot
gefüllt und auf eine Arbeitstemperatur abgekühlt wird,
die deutlich unterhalb der Schmelztemperatur aber oberhalb eines Wertes liegt, bei dem das Silicium seine
Plastizität verliert, daß dann das erstarrte aber noch
auf erhöhter Arbeitstemperatur befindliche Silicium
in dem Boot einen Zonenschmelzprozeß unterzogen wird,
daß schließlich das Silicium auf Zimmertemperatur
abgekühlt und aus dem Boot entfernt wird.

2. Verfahren nach Anspruch 1, d a d u r c h   g e -
k e n n z e i c h n e t , daß die Siliciumschmelze
mindestens auf 1300°C aber höchstens auf 700°C, vorzugsweise auf etwa 1000°C abgekühlt wird.

3. Verfahren nach Anspruch 1 und 2, d a d u r c h
g e k e n n z e i c h n e t , daß jeweils eine einzelne
Schmelzzone durch das Silicium hindurchgezogen wird.

4. Verfahren nach Anspruch 1 und 2, d a d u r c h
g e k e n n z e i c h n e t , daß mehrere Schmelzzonen
gleichzeitig durch das Silicium hindurchgezogen werden.

5. Verfahren nach wenigstens einem der Ansprüche 1 bis 4,
d a d u r c h   g e k e n n z e i c h n e t , daß die
Schmelzzonen mit einer Geschwindigkeit von etwa 1 bis
10 mm pro Minute durch den Stab gezogen werden.

6. Verfahren nach wenigstens einem der Ansprüche 1 bis 5, d a d u r c h   g e k e n n z e i c h n e t, daß der Zonenschmelzprozeß induktiv mittels Hochfrequenz erfolgt.

7. Verfahren nach Anspruch 6, d a d u r c h   g e - k e n n z e i c h n e t, daß die hochfrequente Induktionsheizung bei ca. 0,1 bis 1,5 MHz liegt.

8. Verfahren nach wenigstens einem der Ansprüche 1 bis 5, d a d u r c h   g e k e n n z e i c h n e t, daß der Zonenschmelzprozeß induktiv mittels Mittelfrequenz erfolgt.

9. Verfahren nach Anspruch 8, d a d u r c h   g e - k e n n z e i c h n e t, daß die mittelfrequente Induktionsheizung bei ca. 10 bis 100 kHz liegt.

10. Verfahren nach wenigstens einem der Ansprüche 1 bis 9, d a d u r c h   g e k e n n z e i c h n e t, daß bei der Herstellung von Kurzstäben die Schmelzzonenbreite auf etwa ein Zehntel der Bootslänge eingestellt wird.

11. Verfahren nach Anspruch 10, d a d u r c h   g e - k e n n z e i c h n e t, daß bei einer Bootslänge von 1 bis 1,50 m die Schmelzzone für Kurzstäbe auf eine Breite von etwa 10 cm eingestellt wird.

12. Verfahren nach wenigstens einem der Ansprüche 1 bis 9, d a d u r c h   g e k e n n z e i c h n e t, daß bei der Herstellung von Langstäben, von z. B. 5 bis 10 m, und gleichzeitigem Ziehen mehrerer Schmelzzonen der mittlere Abstand zwischen den einzelnen Schmelzzonen höchstens 50 cm beträgt.

13. Verfahren nach wenigstens einem der Ansprüche 1 bis 12, d a d u r c h   g e k e n n z e i c h n e t, daß der Siliciumstab während des Zonenschmelzprozesses mechanischen Rüttelbewegungen ausgesetzt wird.

14. Verfahren nach wenigstens einem der Ansprüche 1 bis 13, d a d u r c h   g e k e n n z e i c h n e t, daß der Siliciumstab während des Zonenschmelzprozesses mit Ultraschall behandelt wird.

15. Verfahren nach wenigstens einem der Ansprüche 1 bis 14, d a d u r c h   g e k e n n z e i c h n e t, daß der Umschmelzprozeß im Vakuum durchgeführt wird.

16. Verfahren nach wenigstens einem der Ansprüche 1 bis 14, d a d u r c h   g e k e n n z e i c h n e t, daß der Umschmelzprozeß im Schutzgas, z. B. Argon oder Wasserstoff, bei reduziertem Druck durchgeführt wird.

17. Verfahren nach Anspruch 16, d a d u r c h   g e - k e n n z e i c h n e t,  daß der Gießvorgang bei einem Argonpartialdruck von 10 mbar durchgeführt wird.

18. Verfahren nach wenigstens einem der Ansprüche 1 bis 17, d a d u r c h   g e k e n n z e i c h n e t, daß das dem Boot entnommene Barrensilicium von an der Oberfläche haftenden Verunreinigungen befreit wird.

19. Verfahren nach wenigstens einem der Ansprüche 1 bis 18, d a d u r c h   g e k e n n z e i c h n e t, daß ein solchermaßen vorbehandeltes Barrensilicium zur unmittelbaren Verwendung bei Solarelementen in Scheiben geschnitten wird.

0095756

20. Verfahren nach wenigstens einem der Ansprüche 1
bis 18, d a d u r c h  g e k e n n z e i c h n e t,
daß ein solchermaßen vorbehandeltes Barrensilicium in
einem Tiegel eingeschmolzen und mit Hilfe eines vorzugsweise einkristallinen Siliciumkeimes in Stabform
aus diesem Tiegel gezogen wird.

21. Verfahren nach wenigstens einem der Ansprüche 1
bis 18, d a d u r c h  g e k e n n z e i c h n e t,
daß ein solchermaßen vorbehandeltes Barrensilicium
einem tiegelfreien Zonenschmelzen unterzogen wird.

22. Verfahren nach Anspruch 21, d a d u r c h  g e -
k e n n z e i c h n e t,  daß zwei gegeneinander gelegte
und geeignet verspannte halbzylindrische Barren gemeinsam einem tiegelfreien Zonenschmelzen unterzogen werden.

23. Vorrichtung zur Durchführung des Verfahrens nach
wenigstens einem der Ansprüche 1 bis 22, d a d u r c h
g e k e n n z e i c h n e t,  daß ein horizontal
angeordnetes Boot, das durch seine Formgebung die
radiale thermische Ausdehnung des Siliciums aufzunehmen
in der Lage ist, Verwendung findet, und daß eine
Kühl- und Heizeinrichtung, die die Mitteltemperatur
des Siliciums auf der Arbeitstemperatur hält, und
mindestens eine in Längsrichtung des Bootes bewegbare,
das Boot umschließende Induktionsheizspule vorgesehen
sind.

24. Vorrichtung nach Anspruch 23, d a d u r c h
g e k e n n z e i c h n e t,  daß das Boot aus Keramik
besteht.

25. Vorrichtung nach Anspruch 23, d a d u r c h  g e -
k e n n z e i c h n e t,  daß das Boot aus Graphit besteht.

0095756

26. Vorrichtung nach wenigstens einem der Ansprüche 23 bis 25, d a d u r c h g e k e n n z e i c h n e t, daß das Boot als Kurzboot eine Länge von 1 bis 1,5 m besitzt.

27. Vorrichtung nach wenigstens einem der Ansprüche 23 bis 25, d a d u r c h g e k e n n z e i c h n e t, daß das Boot als Langboot eine Länge von mehreren Metern besitzt.

28. Vorrichtung nach wenigstens einem der Ansprüche 23 bis 27, d a d u r c h g e k e n n z e i c h n e t, daß das Boot einen halbkreisförmigen Querschnitt besitzt.

29. Vorrichtung nach wenigstens einem der Ansprüche 1 bis 27, d a d u r c h g e k e n n z e i c h n e t, daß das Boot eine flächendeckende Querschnittsform besitzt.

30. Vorrichtung nach wenigstens einem der Ansprüche 23 bis 29, d a d u r c h g e k e n n z e i c h n e t, daß das Boot mehrfach längsgeteilt ist.

31. Vorrichtung nach Anspruch 30, d a d u r c h g e k e n n z e i c h n e t, daß das Boot aus wenigstens drei elastisch miteinander verbundenen Teilen besteht.

32. Vorrichtung nach wenigstens einem der Ansprüche 23 bis 31, d a d u r c h g e k e n n z e i c h n e t, daß das Boot mit einer die Reaktion des Siliciums mit dem Bootmaterial vermeidenden Zwischenschicht ausgekleidet ist.

0095756

33. Vorrichtung nach wenigstens einem der Ansprüche 23 bis 32, d a d u r c h   g e k e n n z e i c h n e t, daß als Zwischenschicht ein Graphitboot mit einer Vielzahl von über die gesamte Bootsoberfläche gleichmäßig verteilten Längsschlitzen Verwendung findet.

34. Vorrichtung nach wenigstens einem der Ansprüche 23 bis 33, d a d u r c h   g e k e n n z e i c h n e t, daß die Zwischenschicht aus Quarzsand besteht.

35. Vorrichtung nach wenigstens einem der Ansprüche 1 bis 34, d a d u r c h   g e k e n n z e i c h n e t, daß die Zwischenschicht aus mit einem Binder verfestigten Quarzsand besteht.

36. Vorrichtung nach wenigstens einem der Ansprüche 23 bis 35, d a d u r c h   g e k e n n z e i c h n e t, daß die Zwischenschicht aus einem Graphitgewebe besteht.

FIG 1

FIG 2

14

13

Europäisches
Patentamt

**EUROPÄISCHER RECHERCHENBERICHT**

0095756
Nummer der Anmeldung

EP 83 10 5283

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| A | DE-B-1 004 382 (TELEFUNKEN) | | C 30 B 15/00<br>C 30 B 13/00<br>C 30 B 13/16<br>C 30 B 29/06<br>C 01 B 33/02 |
| P | LU-A- 84 499 (SIEMENS) | | |
| A | FR-A-1 197 694 (PHILIPS) | | |

RECHERCHIERTE SACHGEBIETE (Int. Cl. ³)

C 30 B 15/00
C 30 B 13/00
C 01 B 33/02
C 30 B 29/06
C 30 B 13/16

Der vorliegende Recherchenbericht wurde für alle Patentansprüche erstellt.

| Recherchenort | Abschlußdatum der Recherche | Prüfer |
|---|---|---|
| DEN HAAG | 06-09-1983 | BRACKE P.P.J.L. |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503. 03.82